# EUROPEAN PATENT SPECIFICATION

(11) **EP 2 955 534 B1**
(45) Date of publication and mention of the grant of the patent: **16.02.2022**
(21) Application number: 13867226.6
(22) Date of filing: 28.11.2013
(51) Int. Cl.: G01R 33/09, G01R 33/00

(54) **MAGNETIC SENSING APPARATUS, MAGNETIC INDUCTION METHOD AND PREPARATION TECHNIQUE THEREFOR**
MAGNETISCHE ERFASSUNGSVORRICHTUNG, MAGNETISCHES INDUKTIONSVERFAHREN UND HERSTELLUNGSVERFAHREN DAFÜR
APPAREIL DE DÉTECTION MAGNÉTIQUE, PROCÉDÉ D'INDUCTION MAGNÉTIQUE ET TECHNIQUE DE PRÉPARATION DE CELUI-CI

(30) Priority: 21.12.2012 CN 201210563667
(43) Date of publication of application: 16.12.2015
(73) Proprietor: QST Corporation, Shanghai 200050 (CN)
(72) Inventor: WAN, Hong, Shanghai 200050 (CN); WAN, Xudong, Shanghai 200050 (CN); ZHANG, Ting, Shanghai 200050 (CN)
(74) Representative: AWA Sweden AB
(86) International application number: PCT/CN2013/088045
(87) International publication number: WO 2014/101622

(56) References cited:
- WO-A1-2011/123454
- WO-A1-2012/085296
- CN-A- 101 290 343
- CN-A- 101 813 479
- CN-A- 102 385 043
- CN-A- 102 426 344
- CN-U- 202 149 936
- JP-A- 2004 006 752
- JP-A- 2009 216 390
- US-A1- 2005 270 020
- US-A1- 2005 270 020
- US-A1- 2011 244 599

## Description

### FIELD OF THE INVENTION

The present invention belongs to a technical field of electrical communication, refers to a magnetic sensing apparatus, and more particularly to a magnetic three-axis sensing apparatus in a single chip. The present invention also refers to a design method to magnetic sense for the magnetic sensing apparatus above. Meanwhile, the present invention refers to a preparation technique further on for the magnetic sensing apparatus above.

### BACKGROUND OF THE INVENTION

Magnetic sensor is divided by its principle into hall component, magnetic sensing diode, anisotropic magneto-resistance (AMR) component, tunneling magneto-resistance (TMR) component, giant magneto-resistance (GMR) component, induction coil, and superconductive quantum interference magnetometer.

Electrical compass is one of important application field to magnetic sensor. With rapid development of consumer electronics in recent years, more and more smart phones and panel computers assemble electrical compass beside of navigation system, and it makes users feel very convenience. The magnetic sensor developed from two axis to three axis in recent years. Two-axis magnetic sensor, that is to say plane magnetic sensor, can measure magnetic field strength and direction in a plane illustrated by X and Y-axis.

Operating principle of the magnetic sensor in prior art is shown as below. Anisotropic magneto-resistance material is used in the magnetic sensor to measure the magnetic induction strength in a space. Alloy material with crystal structure adopted here is very sensitive to outside magnetic field, and variation of magnetic field lead to variation of resistance of AMR.

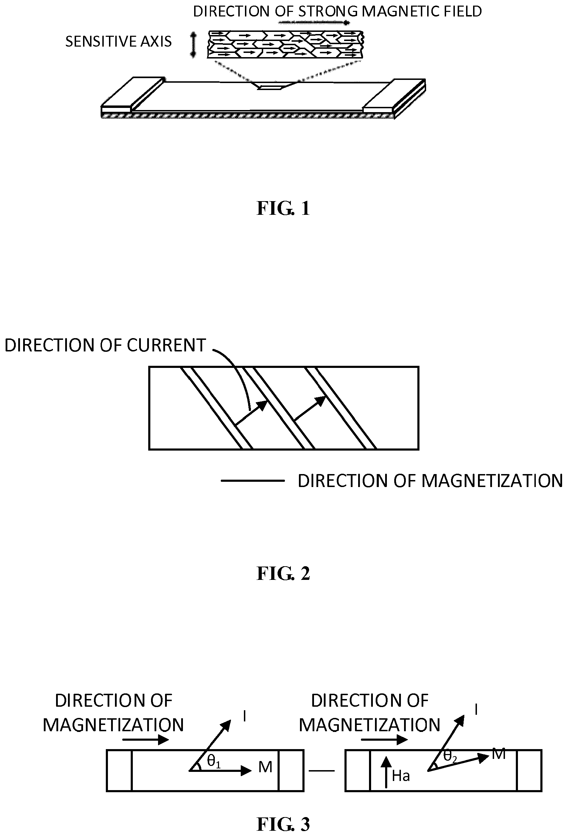

A strong magnetic field is added on an AMR unit to magnetize it in on direction in preparation and application. Then a primary magnetic field is built, and an axis perpendicular to the primary magnetic field is named as sensitive axis of the AMR unit, as illustrated in Fig.1. Metal wires on the AMR material are canted with 45° to make the measurement result variation linearly, and current flow in these wires and AMR material, as illustrated in Fig.2. Angle between the primary magnetic field in the AMR material built by the initial strong magnetic field and the current is 45°.

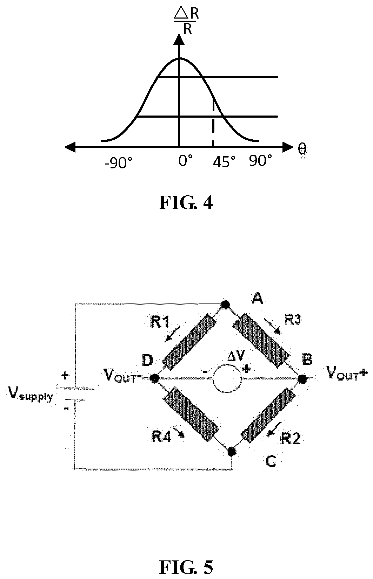

When outside magnetic field Ha exists, direction of the primary magnetic field in AMR unit varies and is not the original direction, and then angel θ between the direction M of magnetic field and current I varies as illustrated in Fig.3. The variation of θ dues to resistance variation of AMR, as that illustrated in Fig.4.

The outside magnetic field can be measured by measuring the resistance variation of AMR unit. In real application, a Wheatstone bridge or half Wheatstone bridge in the magnetic sensor is used for measuring the resistance variation of AMR, in order to improve sensitivity of the component, as illustrated in Fig.5. R1/R2/R3/R4 are ARM resistors with same original state. When outside magnetic field is detected, the resistances of R1/R2 increase ΔR, and these of R3/R4 reduce ΔR. So the output of bridge is zero when outside magnetic field does not exist; and the output of bridge is a small voltage ΔV when outside magnetic field exists.

A sensing part in a plane (two-axis X, and Y) and a sensing part for Z direction are packaged together in system level to realize triaxial sensing for three-axis sensor in prior art. That is to say, the sensing part in the plane and the sensing part for Z direction are set in two independent wafer or chip, and assembled together by packing. It is impossible to realize triaxial sensing in a single wafer/chip in the prior art.

WO 12085296 discloses a three-axes magnetoresistive sensor comprising a substrate covered by an insulating material, a ferromagnetic magnetoresistor extending in the insulating material, and a ferromagnetic concentrator arranged in a groove of the substrate, wherein the concentrator is arranged vertically offset from the magnetoresistor.

US 2011/0244599 in a similar way discloses a three-axes magnetic field sensor comprising a substrate with ferromagnetic sense elements and flux guides, where the flux guides are arranged in substrate grooves, and the sense elements are vertically offset therefrom.

US 2005/270020 A1 disclosed a magnetic sensing device with magnetic sensor units and biasing means which can set or change the magnetization vectors in the sensor units. A second biasing means is located across sloped surfaces.

So, a new magnetic sensing apparatus is needed in the prior art, to product a three-axis sensor in a single wafer/chip.

### SUMMARY OF THE INVENTION

The present invention is as defined by the appended claims.

In the present invention, in order to solve technical problem, a magnetic sensing apparatus is provided. X-axis, Y-axis, and Z-axis sensing components are set in a single wafer or chip, which is easy to produce, has outstanding performance, and has competitive price.

In the present invention, a method to magnetic sense for the magnetic sensing apparatus above is provided. Magnetic data in X-axis, Y-axis, and Z-axis can be induced according the sensing components in the single wafer or chip.

Additionally, a preparation method for the magnetic sensing apparatus is provided, for fabricating the magnetic sensing apparatus assembling X-axis, Y-axis, and Z-axis sensing components in the single wafer or chip.

To solve the technical problem above, a technical proposal is provided in the present invention:
A magnetic sensing apparatus comprises a third direction magnetic sensing component, and the third direction magnetic sensing component comprises:
a substrate having groove in its surface;
a magnetic conductive unit, wherein a main part of the magnetic conductive unit is set in the groove, and a part of it is exposed outside the groove onto the surface of the substrate, in order to collect a magnetic field signal in the third direction and to output the magnetic field signal; and
an inducing unit set on the surface of the substrate, arranged to receive the magnetic field signal in the third direction and to measure the corresponding magnetic field strength and direction in the third direction by the magnetic field signal;
wherein the inducing unit is positioned side by side with the part of the magnetic conductive unit that is exposed outside the groove.

As an optimized embodiment of the present invention, the third direction magnetic sensing component is a perpendicular direction magnetic sensing component;
the magnetic conductive unit is used for collecting the magnetic field signal in the perpendicular direction and output the magnetic signal;
the inducing unit is a magnetic sensor inducing magnetic field paralleled to the surface of the substrate, sets on the surface of the substrate, and comprises a magnetic material layer used for receiving the magnetic field signal in the perpendicular direction output by the magnetic conductive unit, and for measuring corresponding magnetic field strength and direction in the perpendicular direction by the magnetic field signal; the perpendicular direction is perpendicular to the surface of the substrate; and
the magnetic sensing apparatus further comprises a first magnetic sensor, and a second magnetic sensor, arranged to induce magnetic field in first direction, and second direction respectively. The first direction and the second direction are perpendicular.

As an optimized embodiment of the present invention, the third direction magnetic sensing component comprises a peripheral circuit, to calculate magnetic field strength and direction, and output.

As an optimized embodiment of the present invention, an angle between the main part of the magnetic conductive unit and the surface of the substrate is 45°~90°; and the inducing unit is appressed to the surface of the substrate, and paralleled to the surface of the substrate.

As an optimized embodiment of the present invention, the inducing unit is a magnetic sensor paralleled to the surface of the substrate, and consists a part of the three dimensions magnetic sensor together with the magnetic sensors corresponding to the first direction and second direction paralleled to the surface of the substrate.

As an optimized embodiment of the present invention, the inducing units above comprise a magnetic material layer. The magnetic material layer is formed by magnetic resistance material, electrical resistance of which is variable with direction of the magnetic field strength.

As an optimized embodiment of the present invention, the magnetic conductive unit and the inducing units comprise a magnetic material layer; the magnetic material layer is anisotropic magneto-resistance (AMR) material, giant magneto-resistance (GMR) material, or tunneling magneto-resistance (TMR) material. Principle of the magnetic sensing apparatus is anisotropic magneto-resistance (AMR), giant magneto-resistance (GMR), or tunneling magneto-resistance (TMR).

As an optimized embodiment of the present invention, the inducing unit can be used for measuring the first direction and/or second direction magnetic field by different arrangement, and the same inducing unit can also be used for measuring the perpendicular direction magnetic field by transferring the perpendicular direction magnetic field to magnetic field corresponding to the first direction or/and second direction; and any two directions in the first direction, the second direction, and the perpendicular direction are perpendicular.

As an optimized embodiment of the present invention, the inducing unit is a magnetic sensor paralleled to the surface of the substrate, and consists a part of the three dimension magnetic sensor together with the magnetic sensors corresponding to the first direction and second direction paralleled to the surface of the substrate.

As an optimized embodiment of the present invention, the first direction is X-axis direction, the second direction is Y-axis direction, and the perpendicular direction is Z-axis direction.

As an optimized embodiment of the present invention, the apparatus further comprises a second magnetic sensing component, to induce the first direction or the second direction magnetic signal, and then measure the magnetic field strength and magnetic field direction corresponding to the first direction or the second direction by it.

As an optimized embodiment of the present invention, the second magnetic sensing component comprises at least one inducing subunit; wherein each inducing subunit comprises a magnetic material layer. The magnetic material layer is formed by magnetic resistance material, electrical resistance of which is variable with direction of the magnetic field strength.

As an optimized embodiment of the present invention, the second magnetic sensing component comprises four inducing subunit, which are the fifth inducing subunit, the sixth inducing subunit, the seventh inducing subunit, and the eighth inducing subunit;
each of the inducing subunit above comprises a magnetic material layer, on which multiple paralleled electrical nodes are set; and angle between direction of setting the electrical node and direction of magnetization in the magnetic material layer is 10°~80°.

As an optimized embodiment of the present invention, the magnetic conductive unit comprises four magnetic conductive subunits, which are first magnetic conductive subunit, second magnetic conductive subunit, third magnetic conductive subunit, and fourth magnetic conductive subunit;
the inducing unit comprises four inducing subunits, which are first inducing subunit, second inducing subunit, third inducing subunit, and fourth inducing subunit;
the first magnetic conductive subunit is coupled with the first inducing subunit as the first inducing module of the magnetic sensing component in the perpendicular direction;
the second magnetic conductive subunit is coupled with the second inducing subunit as the second inducing module of the magnetic sensing component in the perpendicular direction;
the third magnetic conductive subunit is coupled with the third inducing subunit as the third inducing module of the magnetic sensing component in the perpendicular direction;
the fourth magnetic conductive subunit is coupled with the fourth inducing subunit as the fourth inducing module of the magnetic sensing component in the perpendicular direction;
each inducing subunit above comprises a magnetic material layer, on which multiple paralleled electrical nodes are set; angle between direction of setting the electrical node and direction of magnetization in the magnetic material layer is 10°~80°;
one or multiple columns of grooves are set in the substrate, and a column of grooves is formed by a long groove, or a column of grooves comprises multiple sub-grooves.
each magnetic conductive subunit comprises multiple magnetic accessories, wherein a main part of the magnetic accessory is set in the corresponding groove, and a part of it is exposed outside of the groove; and the exposed part is appressed to the magnetic material layer of the corresponding inducing subunit.

As an optimized embodiment of the present invention, each magnetic accessory has the exposed part outside of the groove, and a distance between the exposed part and the magnetic material layer of the corresponding inducing subunit is 0-20 micrometers.

As an optimized embodiment of the present invention, the magnetic conductive unit and the magnetic material layer of the inducing unit are formed by the same magnetic material, and have the same number of layers deposited in the same step.

As an optimized embodiment of the present invention, the magnetic conductive unit and the magnetic material layer of the inducing unit are formed by different magnetic material deposited in different steps.

A method of inducing a magnetic signal for performing measurements thereof, by means of the magnetic sensing apparatus above comprises the step of inducing a magnetic field in perpendicular direction, and comprises:
collecting a magnetic signal in the third direction and outputting the magnetic signal by means of the magnetic conductive unit;
receiving the magnetic signal in the third direction, output by the magnetic conductive unit, by means of the inducing unit, and measuring the magnetic field strength and magnetic field direction corresponding to the perpendicular direction by the magnetic signal.

As an optimized embodiment of the present invention, the method further comprises the inducing step in first direction and second direction. Induce the magnetic signal in the first direction and second direction, and measure the magnetic field strength and magnetic field direction corresponding to the first direction and the second direction by them.

A method for manufacturing the magnetic sensing apparatus above comprises the following steps:
step S1, provide a substrate;
step S2, set grooves in the surface of the substrate;
step S3, deposit and prepare a magnetic conductive unit, meanwhile deposit an inducing unit on the surface of the substrate, in order to ensure that the magnetic conductive unit and the inducing unit are formed by same material deposited in same step; wherein a main part of the magnetic conductive unit is deposited in the groove, and a part of it is exposed outside the groove onto the surface of the substrate;
step S4, set an electrical node layer on the inducing unit; and
deposit a magnetic material layer needed by a second magnetic sensing component, meanwhile deposit the inducing unit and the magnetic conductive unit in the step S3. The second magnetic sensing component is used for inducing magnetic sensing signal in first direction and second direction, and measure magnetic field strength and magnetic field direction corresponding to the first direction and the second direction by them; that is to say the magnetic material layer needed by the second magnetic sensing component and the inducing unit, and the magnetic conductive unit needed by the magnetic sensing component in perpendicular direction are formed in the same step.

As an optimized embodiment of the present invention, the substrate comprises a CMOS circuit in the step S1.

There is a dielectric layer on the surface of the substrate in the step S2, to isolate the sensing apparatus from the substrate, and the grooves are prepared on the dielectric layer.

The magnetic material layer and a barrier layer, which are single layer or multiple layers independently, are deposited on the substrate of the substrate in the step S3, and then the inducing unit and the magnetic conductive layer are formed in the same step, so the inducing unit and the magnetic conductive layer are formed by same magnetic material in the same step, or formed in different steps; and the main part of the magnetic conductive unit is set in the groove, and a part of it is exposed out the groove and to surface of the substrate.

The advantage of the present invention is that, a inducing unit with X, Y, and Z-axis direction in a single wafer/chip is provided in the magnetic sensing apparatus and the magnetic induction method provided in the present invention, and the peripheral ASIC circuit is integrated optionally on the single chip using fully compatible process with standard CMOS process; and it is easy to product, has outstanding performance, and has competitive price.

### DESCRIPTION OF FIGURES

Fig.1 is schematic diagram for magnetic material of magnetic sensing apparatus in the prior art.
Fig.2 is schematic diagram for structure of the magnetic material and wire of the magnetic sensing apparatus in the prior art.
Fig.3 is schematic diagram for angle between magnetic direction and current direction.
Fig.4 is schematic diagram for θ -R characterization curve of the magnetic material.
Fig.5 is diagram for a wheatstone bridge.
Fig.6 is top view diagram for a part of the magnetic sensing apparatus in the present invention.
Fig.7 is section view diagram for the Fig.1 along AA direction.
Fig.8 is schematic diagram for structure of the magnetic sensing apparatus in the present invention.
Fig.9 is top view diagram for a part of the magnetic sensing apparatus in second embodiment.

### EMBODIMENTS OF THE PRESENT INVENTION

Embodiments of the present invention are illustrated as followed with figures.

### FIRST EMBODIMENT

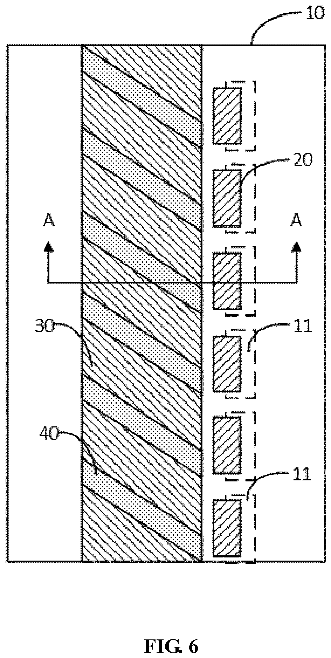

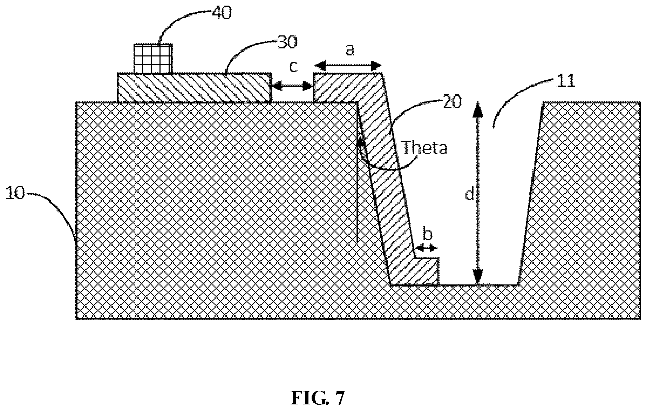

As illustrated in Fig.6 and Fig.7, wherein the Fig.7 is projecting views of Fig.6 along A-A direction. The present invention discloses a magnetic sensing apparatus, which comprises a Z-axis magnetic sensing component. The Z-axis magnetic sensing component comprises: a substrate 10, a magnetic conductive unit 20, and an inducing unit; the substrate 10 may comprise CMOS peripheral circuit.

There is a dielectric layer on surface of the substrate 10, and grooves 11 are in the dielectric layer. One or multiple columns of grooves are set in the substrate. A column of groove comprises multiple sub-grooves 11 in this embodiment.

Main part of the magnetic conductive unit 20 is set in the groove 11, and a part of it is exposed out the groove 11 and to the surface of the substrate, in order to collect magnetic field signal in the Z-axis direction and output the magnetic signal to the inducing unit.

The inducing unit is set on the surface of the substrate, to collect the magnetic field signal in the Z-axis direction output by the magnetic conductive unit 20, and to measure corresponding magnetic field strength and direction in the Z-axis direction by the magnetic field signal. The inducing unit comprises magnetic material layer 30, and multiple parallel nodes 40 are set on the magnetic material layer 30. Meanwhile, the inducing unit is used for sensing magnetic signal in X-axis and Y-axis direction, and measuring the corresponding magnetic field strength and direction in the X-axis and Y-axis direction by the magnetic field signal. The magnetic field in the Z-axis direction is guided to horizontal direction by the inducing unit and then measured, through setting the magnetic conductive unit 20. The magnetic conductive unit 20 and the magnetic material layer 30 of the inducing unit use same magnetic material, have same number of layers, and are deposited in same process; the magnetic conductive unit 20 and the magnetic material layer 30 of the inducing unit can be AMR, TMR and GMR, which is omitted as follows. Of course, the magnetic conductive unit 20 and the magnetic material layer 30 of the inducing unit can also use different magnetic material, or have different number of layers which are fabricated by multiple times of deposition and lithography.

As illustrated in Fig. 7, angle between the main part of the magnetic conductive unit 20 and the plane that comprising the surface of the substrate is 45°~90°, and larger is better. The magnetic material layer 30 of the inducing unit is appressed to the surface of the substrate, and paralleled to the surface of the substrate.

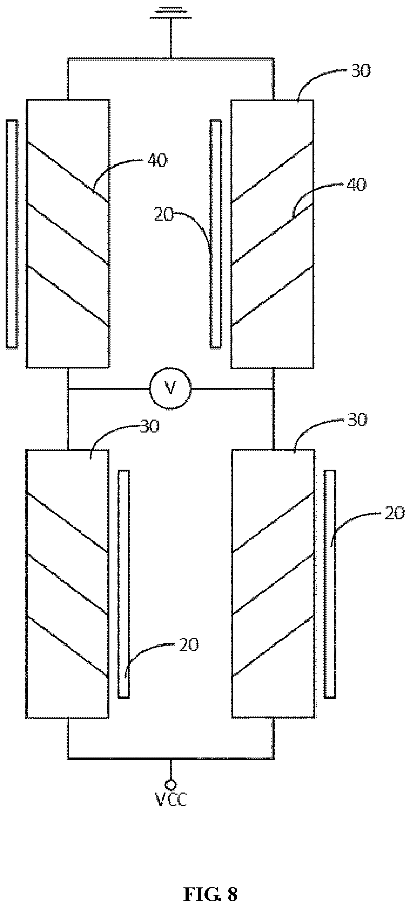

Please refer to Fig. 8, the magnetic conductive unit 20 comprises four magnetic conductive subunits, which are first magnetic conductive subunit, second magnetic conductive subunit, third magnetic conductive subunit, and fourth magnetic conductive subunit. Each magnetic conductive subunit comprises multiple magnetic accessories, main part of the magnetic accessory is set in the corresponding groove 11, and a part of it is exposed out of the groove 11; and the exposed part is appressed to the magnetic material layer of the corresponding inducing subunit. Optimized distance c is 0-20 micrometer, and the typical value is 0 micrometer, 0.1 micrometer, 0.3 micrometer, 0.5 micrometer, 0.8 micrometer, 1 micrometer, and 5 micrometer. Meanwhile, as illustrated in Fig. 7, range of a is 0-2 micrometer (such as 0.5 micrometer, 1 micrometer); range of b is 0-1 micrometer (such as 0 micrometer, 0.1 micrometer, and 0.2 micrometer); range of d is 0.5-10 micrometer (such as 3 micrometer, and 2 micrometer); range of angle Theta is 0-45°(such as 5°).

The inducing unit comprises four inducing subunits, which are first inducing subunit, second inducing subunit, third inducing subunit, and fourth inducing subunit. Each inducing subunit comprises magnetic material layer 30, and multiple parallel electrical nodes 40 are set on the magnetic material layer 30; angle between direction setting the electrical node 40 and magnetization direction of magnetic material layer 30 is 10°~80°, and 45° is optimized.

The first magnetic conductive subunit is coupled with the first inducing subunit as the first inducing module of the magnetic sensing component in the Z-axis; the second magnetic conductive subunit is coupled with the second inducing subunit as the second inducing module of the magnetic sensing component in the Z-axis; the third magnetic conductive subunit is coupled with the third inducing subunit as the third inducing module of the magnetic sensing component in the Z-axis; the fourth magnetic conductive subunit is coupled with the fourth inducing subunit as the fourth inducing module of the magnetic sensing component in the Z-axis.

A Wheatstone bridge is used in the magnetic sensing apparatus as illustrated in Fig. 8, to measure the magnetic field more sensitive. In the field of application, the magnetic field can also be measured by only one magnetic conductive subunit and one inducing substrate, which are omitted here.

In one embodiment of the present invention, the apparatus further comprises X-axis Y-axis magnetic sensing component, to induce the magnetic signal in the X-axis or/and Y-axis, and then measure the corresponding magnetic field strength and direction in the X-axis or/and Y-axis direction by it. The X-axis Y-axis magnetic sensing component is not the inducing unit for the Z-axis magnetic sensing component; the inducing unit for the Z-axis magnetic sensing component is for inducing the direction of Z-axis, and the inducing unit for the X-axis Y-axis magnetic sensing component is for inducing the direction of X-axis or/and Y-axis.

The X-axis or Y-axis magnetic sensing component comprises four inducing subunits, which are fifth inducing subunit, sixth inducing subunit, seventh inducing subunit, and eighth inducing subunit; each inducing subunit above comprises a magnetic material layer, on which multiple paralleled electrical nodes are set; and angle between direction of setting the electrical node and direction of magnetization in the magnetic material layer is 10°~80°, and 45° is optimized. Similarly, the X-axis Y-axis magnetic sensing component can comprise only one inducing unit without Wheatstone bridge.

Structure of the magnetic sensing apparatus in the present invention is introduced above, meanwhile a magnetic induction method is disclosed in the present invention. The method comprises step of inducing the Z-axis magnetic field, and specifically comprises: a magnetic conductive unit collects magnetic signal in the perpendicular direction, and outputs the magnetic signal; an inducing unit receives the magnetic signal in the perpendicular direction output by the magnetic conductive unit, and measures the magnetic field strength and magnetic field direction corresponding to the perpendicular direction by the magnetic signal.

In addition, the method further comprises the magnetic inducing step in X-axis direction and Y-axis direction, which comprises: induce the magnetic signal in the X-axis direction and Y-axis direction, and measure the magnetic field strength and magnetic field direction corresponding to the X-axis direction and Y-axis direction by the magnetic signal.

Meanwhile, a preparation method for the magnetic sensing apparatus is disclosed in the present invention, which comprise the following steps:
[Step S1] provide a substrate, which can comprises CMOS peripheral circuit;
[Step S2] there is a dielectric layer on surface of the substrate, to isolate the sensing apparatus and the substrate, set grooves in surface of the substrate through fabrication method;
[Step S3] deposit the magnetic material and protection layer, which are single layer or multiple layer respectively, and then form the inducing unit and the magnetic conductive unit at the same process through fabrication method, so the magnetic conductive unit and the inducing unit are formed by same material deposited in same step. The main part of the magnetic conductive unit is deposited in the groove, and a part of it is exposed out the groove to the surface of the substrate.

Preferably, the magnetic sensing apparatus in the present invention also comprise X-axis Y-axis magnetic sensing component; the magnetic material layer needed by the X-axis Y-axis magnetic sensing component is deposited in the same step the inducing unit and the magnetic conductive unit are deposited in the step S3; that is to say the magnetic material layer need by the X-axis, Y-axis and the inducing unit and the magnetic conductive unit needed by the Z-axis is fabricated in the same step.

Optionally, multiple times of material depositions and fabrication processes are used for forming the inducing unit and the magnetic conductive unit respectively, that is to say different material layers are used for the both.
[Step S4] set the electrical node layer on the inducing unit and the magnetic material layer of the X-axis Y-axis magnetic sensing component, and then finish the fabrication for the whole sensing apparatus through dielectric material depositing, bonding, and so on.

### SECOND EMBODIMENT

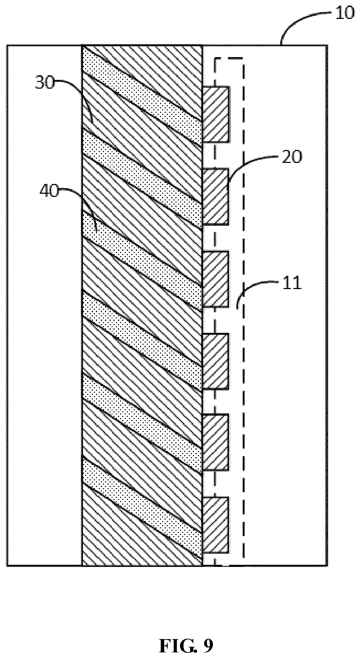

Only difference between the present embodiment and the first embodiment is one groove is shared by multiple magnetic conductive structures in the present invention; please refer to Fig. 9, the groove 11 in the substrate 10 can be on or multiple column, and one column of the groove 11 can be set as a long and narrow groove shared by multiple magnetic accessories.

In addition, the magnetic conductive unit can connect to inducing unit in the present structure, that is to say the distance is 0.

### THIRD EMBODIMENT

In, the present embodiment, the magnetic sensing apparatus in the present invention also comprises CMOS chip, and the substrate mentioned in the first embodiment is set on the CMOS chip. It is to say the magnetic sensing apparatus have functions of the CMOS chip in prior art, That is to say functions of the CMOS chip and the sensing apparatus are integrated into a single chip that have high integration.

### FOURTH EMBODIMENT

In the present embodiment, the magnetic material layer needed by the magnetic conductive unit of the magnetic sensing apparatus, inducing unit and X-axis Y-axis magnetic sensing component is magnetic resistance material, such as NiFe alloy. Wherein, the magnetic resistance material can be multiple layers material, such as GMR and TMR material, that is to say the magnetic resistance material comprises anisotropic magneto-resistance material, giant magneto-resistance material, or tunneling magneto-resistance material; it can be multiple layer or single layer; and thickness and number of layers of the multiple layer material can be adjusted by needed.

In addition, multiple magnetic conductive structure can be coupled to one group of magnetic conductive unit, to make the measurement more sensitive.

### FIFTH EMBODIMENT

In the present embodiment, three dimensions that the magnetic sensing apparatus can induce are not the first direction, the second direction, and the perpendicular direction of X-axis, Y-axis and Z-axis, and the first direction, the second direction, and the perpendicular direction which are perpendicular for any two should meet the requirements.

Principle of the magnetic sensing apparatus is GMR principle, and the magnetic material is GMR material.

### SIXTH EMBODIMENT

In the embodiments above, the magnetic sensor measures and outputs the signal by full Wheatstone bridge. The full Wheatstone bridge comprises four variable arms, that is to say it comprises four magnetic conductive subunits and four inducing subunits, which output the stronger and more effective signal.

Obviously, half bridge, or even quarter bridge, can be used for measuring variation of TMR resistance value (or resistance value of GMR and AMR); two groups of magnetic conductive subunit and two groups of inducing subunit are needed, if using the half bridge for measuring. Only one group of magnetic conductive subunit and one group of inducing subunit are needed, if using the quarter bridge. Here should be specifically mentioned that, just one or two groups of magnetic conductive subunits and inducing subunits can also finish the measurement in the present invention, and it is omitted here.

Even not the bridge but only one magnetic conductive unit and one inducing unit are used for measuring the resistance variation of two termination of magnetic unit, to calculate magnetic field variation.

In conclusion, the magnetic sensing apparatus and magnetic induction method thereof are provided in the present invention, which can set the sensing devices for X-axis, Y-axis, and Z-axis in one wafer or chip, to have good manufacturability, good performance and obvious competitive price.

The description and application of the present invention are illustrative, and do not tend to restrict the present invention to the embodiments above. Any transformation and change are allowed for the embodiments, within the scope of the appended claims, and to replace any embodiment and any components in such a way is well known for common skilled persons in the technical field. The skilled persons in the technical field should be clear that, the present invention can be in other forms, structure, layout, scale, and other devices, materials and components, within the scope of the appended claims.

## Claims

1. , A magnetic sensing apparatus, wherein the apparatus comprises a third direction magnetic sensing component, the third direction magnetic sensing component comprises:
a substrate (10) having a groove (11) in its surface;
a magnetic conductive unit (20), wherein a main part of the magnetic conductive unit (20) is set in the groove (11), and a part of it is exposed outside the groove onto the surface of the substrate (10), in order to collect a magnetic field signal in the third direction and to output the magnetic field signal; and
an inducing unit (30, 40) set on the surface of the substrate (10), arranged to receive the magnetic field signal in the third direction and to measure the corresponding magnetic field strength and direction in the third direction by the magnetic field signal;
wherein the inducing unit (30, 40) is positioned side by side with the part of the magnetic conductive unit (20) that is exposed outside the groove (11).

2. , The magnetic sensing apparatus according to claim 1, wherein:
the third direction magnetic sensing component is a perpendicular direction magnetic sensing component;
the magnetic conductive unit (20) is used for collecting the magnetic field signal in the perpendicular direction and output the magnetic signal;
the inducing unit (30, 40) is a magnetic sensor inducing magnetic field paralleled to the surface of the substrate (10), sets on the surface of the substrate (10), and comprises a magnetic material layer (30) used for receiving the magnetic field signal in the perpendicular direction output by the magnetic conductive unit (20), and for measuring corresponding magnetic field strength and direction in the perpendicular direction by the magnetic field signal; the perpendicular direction is perpendicular to the surface of the substrate (10); and
the magnetic sensing apparatus further comprises a first magnetic sensor, and a second magnetic sensor, arranged to induce magnetic field in first direction, and second direction respectively, wherein the first direction and the second direction are perpendicular.

3. , The magnetic sensing apparatus according to claim 1, wherein:
the third direction magnetic sensing component comprises a peripheral circuit, to calculate magnetic field strength and direction, and output.

4. , The magnetic sensing apparatus according to claim 1, wherein:
an angle between the main part of the magnetic conductive unit and the surface of the substrate is 45°~90°; and the inducing unit (30, 40) is appressed to the surface of the substrate (10), and paralleled to the surface of the substrate (10).

5. , The magnetic sensing apparatus according to claim 1, wherein:
the inducing unit (30, 40) is a magnetic sensor paralleled to the surface of the substrate (10), and consists a part of the three dimensions magnetic sensor together with the magnetic sensors corresponding to the first direction and second direction paralleled to the surface of the substrate (10).

6. , The magnetic sensing apparatus according to claim 5, wherein:
the first direction is X-axis direction, the second direction is Y-axis direction, and the third direction is Z-axis direction.

7. , The magnetic sensing apparatus according to claim 1, wherein:
the apparatus further comprises a second magnetic sensing component, to induce the first direction or/and the second direction magnetic signal, and then measure the magnetic field strength and magnetic field direction corresponding to the first direction or/and the second direction by it.

8. , The magnetic sensing apparatus according to claim 7, wherein:
the second magnetic sensing component comprises at least one inducing subunit; wherein each inducing subunit comprises a magnetic material layer, and the magnetic material layer is formed by magnetic resistance material, electrical resistance of which is variable with direction of the magnetic field strength.

9. , The magnetic sensing apparatus according to anyone of claims 1 to 8, wherein:
the magnetic conductive unit (20) and the inducing units (30, 40) comprise magnetic material layer respectively;
wherein the magnetic material of the magnetic material layer is anisotropic magneto-resistance material, giant magneto-resistance material, or tunneling magneto-resistance material; and
wherein principle of the magnetic sensing apparatus is anisotropic magneto-resistance, giant magneto-resistance, or tunneling magneto-resistance.

10. , The magnetic sensing apparatus according to claim 1, wherein:
the magnetic conductive unit (20) comprises four magnetic conductive subunits, which are first magnetic conductive subunit, second magnetic conductive subunit, third magnetic conductive subunit, and fourth magnetic conductive subunit;
the inducing unit (30, 40) comprises four inducing subunits, which are first inducing subunit, second inducing subunit, third inducing subunit, and fourth inducing subunit;
the first magnetic conductive subunit is coupled with the first inducing subunit as the first inducing module of the magnetic sensing component in the third direction;
the second magnetic conductive subunit is coupled with the second inducing subunit as the second inducing module of the magnetic sensing component in the third direction;
the third magnetic conductive subunit is coupled with the third inducing subunit as the third inducing module of the magnetic sensing component in the third direction;
the fourth magnetic conductive subunit is coupled with the fourth inducing subunit as the fourth inducing module of the magnetic sensing component in the third direction;
each inducing subunit above comprises a magnetic material layer, electrical resistance of which is variable with direction of the magnetic field strength;
one or multiple columns of grooves are set in the substrate, and a column of grooves is formed by a long groove, or a column of grooves comprises multiple sub-grooves; and
each magnetic conductive subunit comprises multiple magnetic accessories,
wherein a main part of the magnetic accessory is set in the corresponding groove, and a part of it is exposed outside of the groove; and the exposed part is appressed to the magnetic material layer of the corresponding inducing subunit.

11. , The magnetic sensing apparatus according to claim 10, wherein:
each magnetic accessory has the exposed part outside of the groove, and a distance between the exposed part and the magnetic material layer of the corresponding inducing subunit is 0-20 micrometers.

12. , The magnetic sensing apparatus according to anyone of claims 1 to 11, wherein:
the magnetic conductive unit (20) and the magnetic material layer (30) of the inducing unit (30, 40) are formed by the same magnetic material, and have the same number of layers deposited in the same step.

13. , The magnetic sensing apparatus according to anyone of claims 1 to 11, wherein:
the magnetic conductive unit (20) and the magnetic material layer (30) of the inducing unit (30, 40) are formed by different magnetic material deposited in different steps.

14. , A method of inducing a magnetic signal for performing measurements thereof, by means of the magnetic sensing apparatus according to anyone of the preceding claims, wherein the method comprises the step of inducing a magnetic field in the third direction, comprising:
collecting a magnetic signal in the third direction and outputting the magnetic signal by means of the magnetic conductive unit (20);
receiving the magnetic signal in the third direction, output by the magnetic conductive unit (20), by means of the inducing unit (30, 40), and measuring the magnetic field strength and magnetic field direction corresponding to the third direction by the magnetic signal.

15. , The method according to claim 14, wherein:
the method further comprises the inducing step in first direction and second direction, comprising inducing the magnetic signal in the first direction and second direction, and measuring the magnetic field strength and magnetic field direction corresponding to the first direction and the second direction by them.

16. , A method for manufacturing the magnetic sensing apparatus according to anyone of claims 1 to 13, comprising the following steps:
step 51, providing a substrate (10);
step S2, setting grooves (11) in the surface of the substrate (10);
step S3, depositing and preparing a magnetic conductive unit (20), meanwhile depositing an inducing unit (30, 40) on the surface of the substrate (10), in order to ensure that the magnetic conductive unit (20) and the inducing unit (30, 40) are formed by the same material deposited in the same step; wherein a main part of the magnetic conductive unit (20) is deposited in the groove (11), and a part of it is exposed outside the groove (11) onto the surface of the substrate (10);
step S4, setting an electrical node layer (40) on the inducing unit (30, 40); depositing a magnetic material layer needed by a second and a third magnetic sensing component, meanwhile depositing the inducing unit and the magnetic conductive unit in the step S3, wherein the second and the third magnetic sensing components are used for inducing a magnetic sensing signal in a first direction and a second direction, and measuring magnetic field strength and magnetic field direction corresponding to the first direction and the second direction by them; and
forming the magnetic material layer needed by the second and third magnetic sensing components and the inducing unit, and the magnetic conductive unit (20) needed by the magnetic sensing component in the third direction in the same step.

17. , The method according to claim 16, wherein:
the substrate comprises a CMOS (Complementary metal-oxide-semiconductor) circuit in the step S1;
there is a dielectric layer on the surface of the substrate in the step S2, to isolate the sensing apparatus from the substrate, and the grooves (11) are prepared on the dielectric layer by fabrication process; and
the magnetic material layer and a barrier layer, which are single layer or
multiple layers independently, are deposited on the substrate of the substrate in the step S3, and then the inducing unit and the magnetic conductive layer are formed in the same step, so the inducing unit and the magnetic conductive layer are formed by same magnetic material in the same step; and the main part of the magnetic conductive unit is set in the groove, and a part of it is exposed out the groove and to surface of the substrate; or different magnetic materials formed in different steps.

## Patentansprüche

1. Magnetische Erfassungsvorrichtung, wobei die Vorrichtung eine magnetische Erfassungskomponente für eine dritte Richtung umfasst, wobei die magnetische Erfassungskomponente für eine dritte Richtung umfasst:
ein Substrat (10), das eine Nut (11) in seiner Oberfläche aufweist;
eine magnetisch leitfähige Einheit (20), wobei ein Hauptteil der magnetisch leitfähigen Einheit (20) in die Nut (11) eingesetzt ist und ein Teil von ihr außerhalb der Nut auf der Oberfläche des Substrats (10) freiliegt, um ein Magnetfeldsignal in der dritten Richtung zu erfassen und das Magnetfeldsignal auszugeben; und
eine induzierende Einheit (30, 40), die auf der Oberfläche des Substrats (10) aufgesetzt ist und dafür ausgelegt ist, das Magnetfeldsignal in der dritten Richtung zu empfangen und die entsprechende Magnetfeldstärke und -richtung in der dritten Richtung mithilfe des Magnetfeldsignals zu messen;
wobei die induzierende Einheit (30, 40) Seite an Seite mit dem Teil der magnetisch leitfähigen Einheit (20) positioniert ist, welcher außerhalb der Nut (11) freiliegt.

2. Magnetische Erfassungsvorrichtung nach Anspruch 1, wobei:
die magnetische Erfassungskomponente für eine dritte Richtung eine magnetische Erfassungskomponente für eine senkrechte Richtung ist;
die magnetisch leitfähige Einheit (20) zum Erfassen des Magnetfeldsignals in der senkrechten Richtung und Ausgeben des Magnetsignals verwendet wird;
die induzierende Einheit (30, 40) ein Magnetsensor ist, der ein zur Oberfläche des Substrats (10) parallel ausgerichtetes Magnetfeld induziert, auf der Oberfläche des Substrats (10) aufsitzt und eine magnetische Materialschicht (30) umfasst, die verwendet wird, um das von der magnetisch leitfähigen Einheit (20) ausgegebene Magnetfeldsignal in der senkrechten Richtung zu empfangen und um die entsprechende Magnetfeldstärke und -richtung in der senkrechten Richtung mithilfe des Magnetfeldsignals zu messen; die senkrechte Richtung senkrecht zur Oberfläche des Substrats (10) ist; und
die magnetische Erfassungsvorrichtung ferner einen ersten Magnetsensor und einen zweiten Magnetsensor umfasst, die dafür ausgelegt sind, ein Magnetfeld in einer ersten Richtung bzw. zweiten Richtung zu induzieren, wobei die erste Richtung und die zweite Richtung zueinander senkrecht sind.

3. Magnetische Erfassungsvorrichtung nach Anspruch 1, wobei:
die magnetische Erfassungskomponente für eine dritte Richtung eine periphere Schaltung umfasst, um Magnetfeldstärke und -richtung zu berechnen und auszugeben.

4. Magnetische Erfassungsvorrichtung nach Anspruch 1, wobei:
ein Winkel zwischen dem Hauptteil der magnetisch leitfähigen Einheit und der Oberfläche des Substrats 45° ÷ 90° beträgt und die induzierende Einheit (30, 40) an die Oberfläche des Substrats (10) angedrückt und parallel zur Oberfläche des Substrats (10) ausgerichtet ist.

5. Magnetische Erfassungsvorrichtung nach Anspruch 1, wobei:
die induzierende Einheit (30, 40) ein Magnetsensor ist, der zur Oberfläche des Substrats (10) parallel ausgerichtet ist, und einen Teil des Magnetsensors für drei Dimensionen darstellt, zusammen mit den der ersten Richtung und zweiten Richtung entsprechenden Magnetsensoren, die zur Oberfläche des Substrats (10) parallel ausgerichtet sind.

6. Magnetische Erfassungsvorrichtung nach Anspruch 5, wobei:
die erste Richtung die X-Achsen-Richtung ist, die zweite Richtung die Y-Achsen-Richtung ist und die dritte Richtung die Z-Achsen-Richtung ist.

7. Magnetische Erfassungsvorrichtung nach Anspruch 1, wobei:
die Vorrichtung ferner eine zweite magnetische Erfassungskomponente umfasst, um das Magnetsignal der ersten Richtung oder/und der zweiten Richtung zu induzieren und danach mithilfe desselben die Magnetfeldstärke und Magnetfeldrichtung zu messen, die der ersten Richtung oder/und der zweiten Richtung entsprechen.

8. Magnetische Erfassungsvorrichtung nach Anspruch 7, wobei:
die zweite magnetische Erfassungskomponente wenigstens eine induzierende Untereinheit umfasst; wobei jede induzierende Untereinheit eine magnetische Materialschicht umfasst und die magnetische Materialschicht von Magnetowiderstandsmaterial gebildet wird, dessen elektrischer Widerstand mit der Richtung der Magnetfeldstärke variabel ist.

9. Magnetische Erfassungsvorrichtung nach einem der Ansprüche 1 bis 8, wobei:
die magnetisch leitfähige Einheit (20) und die induzierenden Einheiten (30, 40) jeweils eine magnetische Materialschicht umfassen;
wobei das magnetische Material der magnetischen Materialschicht anisotropes Magnetowiderstandsmaterial, Riesenmagnetowiderstandsmaterial oder Tunnelmagnetowiderstandsmaterial ist; und
wobei das Prinzip der magnetischen Erfassungsvorrichtung anisotroper Magnetowiderstand, Riesenmagnetowiderstand oder Tunnelmagnetowiderstand ist.

10. Magnetische Erfassungsvorrichtung nach Anspruch 1, wobei:
die magnetisch leitfähige Einheit (20) vier magnetisch leitfähige Untereinheiten umfasst, welche eine erste magnetisch leitfähige Untereinheit, eine zweite magnetisch leitfähige Untereinheit, eine dritte magnetisch leitfähige Untereinheit und eine vierte magnetisch leitfähige Untereinheit sind;
die induzierende Einheit (30, 40) vier induzierende Untereinheiten umfasst, welche eine erste induzierende Untereinheit, eine zweite induzierende Untereinheit, eine dritte induzierende Untereinheit und eine vierte induzierende Untereinheit sind;
die erste magnetisch leitfähige Untereinheit mit der ersten induzierenden Untereinheit als das erste induzierende Modul der magnetischen Erfassungskomponente in der dritten Richtung gekoppelt ist;
die zweite magnetisch leitfähige Untereinheit mit der zweiten induzierenden Untereinheit als das zweite induzierende Modul der magnetischen Erfassungskomponente in der dritten Richtung gekoppelt ist;
die dritte magnetisch leitfähige Untereinheit mit der dritten induzierenden Untereinheit als das dritte induzierende Modul der magnetischen Erfassungskomponente in der dritten Richtung gekoppelt ist;
die vierte magnetisch leitfähige Untereinheit mit der vierten induzierenden Untereinheit als das vierte induzierende Modul der magnetischen Erfassungskomponente in der dritten Richtung gekoppelt ist;
jede oben genannte induzierende Untereinheit eine magnetische Materialschicht umfasst, deren elektrischer Widerstand mit der Richtung der Magnetfeldstärke variabel ist;
eine oder mehrere Reihen von Nuten in dem Substrat angebracht sind und eine Reihe von Nuten von einer langen Nut gebildet wird oder eine Reihe von Nuten mehrere Teilnuten umfasst; und
jede magnetisch leitfähige Untereinheit mehrere magnetische Zusatzteile umfasst, wobei ein Hauptteil des magnetischen Zusatzteils in die entsprechende Nut eingesetzt ist und ein Teil von ihm außerhalb der Nut freiliegt; und der freiliegende Teil an die magnetische Materialschicht der entsprechenden induzierenden Untereinheit angedrückt ist.

11. Magnetische Erfassungsvorrichtung nach Anspruch 10, wobei:
jedes magnetische Zusatzteil den freiliegenden Teil außerhalb der Nut aufweist und ein Abstand zwischen dem freiliegenden Teil und der magnetischen Materialschicht der entsprechenden induzierenden Untereinheit 0-20 Mikrometer beträgt.

12. Magnetische Erfassungsvorrichtung nach einem der Ansprüche 1 bis 11, wobei:
die magnetisch leitfähige Einheit (20) und die magnetische Materialschicht (30) der induzierenden Einheit (30, 40) von demselben magnetischen Material gebildet werden und dieselbe Anzahl von Schichten aufweisen, die in demselben Schritt aufgebracht werden.

13. Magnetische Erfassungsvorrichtung nach einem der Ansprüche 1 bis 11, wobei:
die magnetisch leitfähige Einheit (20) und die magnetische Materialschicht (30) der induzierenden Einheit (30, 40) von unterschiedlichem magnetischen Material gebildet werden, das in verschiedenen Schritten aufgebracht wird.

14. Verfahren zum Induzieren eines Magnetsignals zum Durchführen von Messungen desselben mittels der magnetischen Erfassungsvorrichtung nach einem der vorhergehenden Ansprüche, wobei das Verfahren den Schritt des Induzierens eines Magnetfeldes in der dritten Richtung umfasst, umfassend:
Erfassen eines Magnetsignals in der dritten Richtung und Ausgeben des Magnetsignals mittels der magnetisch leitfähigen Einheit (20);
Empfangen des Magnetsignals in der dritten Richtung, das von der magnetisch leitfähigen Einheit (20) ausgegeben wurde, mittels der induzierenden Einheit (30, 40) und Messen der Magnetfeldstärke und Magnetfeldrichtung, die der dritten Richtung entsprechen, mithilfe des Magnetsignals.

15. Verfahren nach Anspruch 14, wobei:
das Verfahren ferner den Induzierungsschritt in einer ersten Richtung und einer zweiten Richtung umfasst, der das Induzieren der Magnetsignale in der ersten Richtung und zweiten Richtung und das Messen der Magnetfeldstärke und Magnetfeldrichtung, die der ersten Richtung und der zweiten Richtung entsprechen, mithilfe derselben umfasst.

16. Verfahren zum Herstellen der magnetischen Erfassungsvorrichtung nach einem der Ansprüche 1 bis 13, welches die folgenden Schritte umfasst:
Schritt S1, Bereitstellen eines Substrats (10);
Schritt S2, Ausbilden von Nuten (11) in der Oberfläche des Substrats (10);
Schritt S3, Aufbringen und Ausbilden einer magnetisch leitfähigen Einheit (20), währenddessen Aufbringen einer induzierenden Einheit (30, 40) auf die Oberfläche des Substrats (10), um sicherzustellen, dass die magnetisch leitfähige Einheit (20) und die induzierende Einheit (30, 40) aus demselben Material ausgebildet werden, das in demselben Schritt aufgebracht wird; wobei ein Hauptteil der magnetisch leitfähigen Einheit (20) in die Nut (11) eingebracht wird und ein Teil von ihr außerhalb der Nut (11) auf der Oberfläche des Substrats (10) freiliegt;
Schritt S4, Anbringen einer elektrischen Knotenschicht (40) auf der induzierenden Einheit (30, 40);
Aufbringen einer magnetischen Materialschicht, die von einer zweiten und einer dritten magnetischen Erfassungskomponente benötigt wird, währenddessen Aufbringen der induzierenden Einheit und der magnetisch leitfähigen Einheit in Schritt S3, wobei die zweite und die dritte magnetische Erfassungskomponente verwendet werden, um Magneterfassungssignale in einer ersten Richtung und einer zweiten Richtung zu induzieren und die Magnetfeldstärke und Magnetfeldrichtung, die der ersten Richtung und der zweiten Richtung entsprechen, mithilfe derselben zu messen; und
Ausbilden der magnetischen Materialschicht, die von der zweiten und dritten magnetischen Erfassungskomponente und der induzierenden Einheit benötigt wird, und der magnetisch leitfähigen Einheit (20), die von der magnetischen Erfassungskomponente in der dritten Richtung benötigt wird, in demselben Schritt.

17. Verfahren nach Anspruch 16, wobei:
das Substrat eine CMOS (Complementary Metal-Oxide-Semiconductor, komplementärer Metall-Oxid-Halbleiter) Schaltung in Schritt S1 umfasst;
eine Dielektrikumsschicht auf der Oberfläche des Substrats in Schritt S2 vorhanden ist, um die Erfassungsvorrichtung von dem Substrat zu isolieren, und die Nuten (11) auf der Dielektrikumsschicht durch den Herstellungsprozess ausgebildet werden; und
die magnetische Materialschicht und eine Sperrschicht, welche eine einzige Schicht oder mehrere Schichten unabhängig voneinander sind, auf das Substrat des Substrats in Schritt S3 aufgebracht werden und danach die induzierende Einheit und die magnetisch leitfähige Schicht in demselben Schritt ausgebildet werden, so dass die induzierende Einheit und die magnetisch leitfähige Schicht von demselben magnetischen Material in demselben Schritt gebildet werden; und der Hauptteil der magnetisch leitfähigen Einheit in die Nut eingesetzt wird und ein Teil von ihr außerhalb der Nut und an der Oberfläche des Substrats freiliegt; oder von verschiedenen magnetischen Materialien, die in verschiedenen Schritten gebildet werden.

## Revendications

1. Appareil de détection magnétique, dans lequel l'appareil comprend un composant de détection magnétique dans la troisième direction, le composant de détection magnétique dans la troisième direction comprend :
un substrat (10) ayant une rainure (11) dans sa surface ;
une unité conductrice magnétique (20), dans laquelle une partie principale de l'unité conductrice magnétique (20) est placée dans la rainure (11), et une partie de celle-ci est exposée à l'extérieur de la rainure sur la surface du substrat (10), afin de collecter un signal de champ magnétique dans la troisième direction et de délivrer le signal de champ magnétique ; et
une unité d'induction (30, 40) placée sur la surface du substrat (10), agencée pour recevoir le signal de champ magnétique dans la troisième direction et pour mesurer l'intensité et la direction de champ magnétique correspondantes dans la troisième direction par le signal de champ magnétique ;
dans lequel l'unité d'induction (30, 40) est positionnée côte à côte avec la partie de l'unité conductrice magnétique (20) qui est exposée à l'extérieur de la rainure (11).

2. Appareil de détection magnétique selon la revendication 1, dans lequel :
le composant de détection magnétique de troisième direction est un composant de détection magnétique de direction perpendiculaire ;
l'unité conductrice magnétique (20) est utilisée pour collecter le signal de champ magnétique dans la direction perpendiculaire et délivrer le signal magnétique ;
l'unité d'induction (30, 40) est un capteur magnétique induisant un champ magnétique parallèle à la surface du substrat (10), placé sur la surface du substrat (10), et comprend une couche de matériau magnétique (30) utilisée pour recevoir le signal de champ magnétique dans la direction perpendiculaire délivré par l'unité conductrice magnétique (20), et pour mesurer l'intensité et la direction de champ magnétique correspondantes dans la direction perpendiculaire par le signal de champ magnétique ; la direction perpendiculaire est perpendiculaire à la surface du substrat (10) ; et
l'appareil de détection magnétique comprend en outre un premier capteur magnétique et un deuxième capteur magnétique, agencés pour induire un champ magnétique dans la première direction et la deuxième direction respectivement, la première direction et la deuxième direction étant perpendiculaires.

3. Appareil de détection magnétique selon la revendication 1, dans lequel :
le composant de détection magnétique de troisième direction comprend un circuit périphérique, pour calculer l'intensité et la direction du champ magnétique, et une sortie.

4. Appareil de détection magnétique selon la revendication 1, dans lequel :
un angle entre la partie principale de l'unité conductrice magnétique et la surface du substrat est de 45°~90°; et l'unité d'induction (30, 40) est appliquée sur la surface du substrat (10) et parallèle à la surface du substrat (10).

5. Appareil de détection magnétique selon la revendication 1, dans lequel :
l'unité d'induction (30, 40) est un capteur magnétique parallèle à la surface du substrat (10), et se compose d'une partie du capteur magnétique tridimensionnel ainsi que des capteurs magnétiques correspondant à la première direction et à la deuxième direction parallèle à la surface du substrat (10).

6. Appareil de détection magnétique selon la revendication 5, dans lequel :
la première direction est la direction de l'axe X, la deuxième direction est la direction de l'axe Y et la troisième direction est la direction de l'axe Z.

7. Appareil de détection magnétique selon la revendication 1, dans lequel :
l'appareil comprend en outre un deuxième composant de détection magnétique, pour induire le signal magnétique de la première direction ou/et de la deuxième direction, puis mesurer l'intensité du champ magnétique et la direction du champ magnétique correspondant à la première direction ou/et à la deuxième direction par celui-ci.

8. Appareil de détection magnétique selon la revendication 7, dans lequel :
le deuxième composant de détection magnétique comprend au moins une sous-unité d'induction ; dans lequel chaque sous-unité d'induction comprend une couche de matériau magnétique, et la couche de matériau magnétique est formée d'un matériau à résistance magnétique, dont la résistance électrique est variable proportionnellement à la direction de l'intensité du champ magnétique.

9. Appareil de détection magnétique selon une quelconque des revendications 1 à 8, dans lequel :
l'unité conductrice magnétique (20) et les unités inductrices (30, 40) comprennent respectivement une couche de matériau magnétique ;
dans lequel le matériau magnétique de la couche de matériau magnétique est un matériau à magnétorésistance anisotrope, un matériau à magnétorésistance géante ou un matériau à magnétorésistance à effet tunnel ; et
dans lequel le principe de l'appareil de détection magnétique est une magnétorésistance anisotrope, une magnétorésistance géante ou une magnétorésistance à effet tunnel.

10. Appareil de détection magnétique selon la revendication 1, dans lequel :
l'unité conductrice magnétique (20) comprend quatre sous-unités conductrices magnétiques, qui sont une première sous-unité conductrice magnétique, une deuxième sous-unité conductrice magnétique, une troisième sous-unité conductrice magnétique et une quatrième sous-unité conductrice magnétique ;
l'unité d'induction (30, 40) comprend quatre sous-unités d'induction, qui sont une première sous-unité d'induction, une deuxième sous-unité d'induction, une troisième sous-unité d'induction et une quatrième sous-unité d'induction ;
la première sous-unité conductrice magnétique est couplée à la première sous-unité d'induction en tant que premier module d'induction du composant de détection magnétique dans la troisième direction ;
la deuxième sous-unité conductrice magnétique est couplée à la deuxième sous-unité d'induction en tant que deuxième module d'induction du composant de détection magnétique dans la troisième direction ;
la troisième sous-unité conductrice magnétique est couplée à la troisième sous-unité d'induction en tant que troisième module d'induction du composant de détection magnétique dans la troisième direction ;
la quatrième sous-unité conductrice magnétique est couplée à la quatrième sous-unité d'induction en tant que quatrième module d'induction du composant de détection magnétique dans la troisième direction ;
chaque sous-unité d'induction ci-dessus comprend une couche de matériau magnétique, dont la résistance électrique est variable proportionnellement à la direction de l'intensité du champ magnétique ; une ou plusieurs colonnes de rainures sont disposées dans le substrat, et une colonne de rainures est formée par une longue rainure, ou une colonne de rainures comprend plusieurs sous-rainures ; et
chaque sous-unité conductrice magnétique comprend de multiples accessoires magnétiques, dans lequel une partie principale de l'accessoire magnétique est placée dans la rainure correspondante, et une partie de celui-ci est exposée à l'extérieur de la rainure ; et la partie exposée est appliquée sur la couche de matériau magnétique de la sous-unité d'induction correspondante.

11. Appareil de détection magnétique selon la revendication 10, dans lequel :
chaque accessoire magnétique a la partie exposée à l'extérieur de la rainure, et une distance entre la partie exposée et la couche de matériau magnétique de la sous-unité d'induction correspondante est de 0 à 20 micromètres.

12. Appareil de détection magnétique selon une quelconque des revendications 1 à 11, dans lequel:
l'unité conductrice magnétique (20) et la couche de matériau magnétique (30) de l'unité inductrice (30, 40) sont formées par le même matériau magnétique, et ont le même nombre de couches déposées dans la même étape.

13. Appareil de détection magnétique selon une quelconque des revendications 1 à 11, dans lequel:
l'unité conductrice magnétique (20) et la couche de matériau magnétique (30) de l'unité inductrice (30, 40) sont formées par un matériau magnétique différent déposé en différentes étapes.

14. Procédé d'induction d'un signal magnétique pour effectuer des mesures de celui-ci, au moyen de l'appareil de détection magnétique selon une quelconque des revendications précédentes, dans lequel le procédé comprend l'étape d'induction d'un champ magnétique dans la troisième direction, comprenant de:
collecter un signal magnétique dans la troisième direction et délivrer le signal magnétique au moyen de l'unité conductrice magnétique (20) ;
recevoir le signal magnétique dans la troisième direction, délivré par l'unité conductrice magnétique (20), au moyen de l'unité d'induction (30, 40), et mesurer l'intensité du champ magnétique et la direction du champ magnétique correspondant à la troisième direction par le signal magnétique.

15. Procédé selon la revendication 14, dans lequel:
le procédé comprend en outre l'étape d'induction dans la première direction et la deuxième direction, comprenant l'induction du signal magnétique dans la première direction et la deuxième direction, et la mesure de l'intensité du champ magnétique et de la direction du champ magnétique correspondant à la première direction et à la deuxième direction par celles-ci.

16. Procédé de fabrication de l'appareil de détection magnétique selon une quelconque des revendications 1 à 13, comprenant les étapes suivantes :
étape SI, fourniture d'un substrat (10) ;
étape S2, réalisation de rainures (11) dans la surface du substrat (10) ;
étape S3, dépôt et préparation d'une unité conductrice magnétique (20), en déposant une unité d'induction (30, 40) sur la surface du substrat (10), afin de s'assurer que l'unité conductrice magnétique (20) et l'unité inductrice (30, 40) sont formés par le même matériau déposé dans la même étape ; dans lequel une partie principale de l'unité conductrice magnétique (20) est déposée dans la rainure (11), et une partie de celui-ci est exposée à l'extérieur de la rainure (11) sur la surface du substrat (10) ;
étape S4, établissement d'une couche de nœud électrique (40) sur l'unité d'induction (30, 40); dépôt d'une couche de matériau magnétique nécessaire à un deuxième et un troisième composant de détection magnétique, tout en déposant l'unité d'induction et l'unité conductrice magnétique à l'étape S3, dans lequel les deuxième et troisième composants de détection magnétique sont utilisés pour induire un signal de détection magnétique dans une première direction et une deuxième direction, et mesurer l'intensité du champ magnétique et la direction du champ magnétique correspondant à la première direction et à la deuxième direction par eux ; et
formation de la couche de matériau magnétique nécessaire aux deuxième et troisième composants de détection magnétique et à l'unité d'induction, et à l'unité conductrice magnétique (20) requise par le composant de détection magnétique dans la troisième direction au cours de la même étape.

17. Procédé selon la revendication 16, dans lequel:
le substrat comprend un circuit CMOS (semi-conducteur complémentaire à oxyde métallique) à l'étape SI ; il y a une couche diélectrique sur la surface du substrat à l'étape S2, pour isoler l'appareil de détection du substrat, et les rainures (11) sont préparées sur la couche diélectrique par un processus de fabrication ; et
la couche de matériau magnétique et une couche barrière, qui sont une couche unique ou plusieurs couches indépendamment, sont déposées sur le substrat du substrat à l'étape S3, puis l'unité d'induction et la couche conductrice magnétique sont formées à la même étape, de sorte l'unité d'induction et la couche conductrice magnétique sont formées par le même matériau magnétique dans la même étape ; et la partie principale de l'unité conductrice magnétique est placée dans la rainure, et une partie de celle-ci est exposée hors de la rainure et jusqu'à la surface du substrat ; ou différents matériaux magnétiques formés dans différentes étapes.
